(19) **Europäisches Patentamt / European Patent Office / Office européen des brevets**

(11) **EP 3 092 144 B1**

(12) **FASCICULE DE BREVET EUROPEEN**

(45) Date de publication et mention
de la délivrance du brevet:
**13.11.2019 Bulletin 2019/46**

(21) Numéro de dépôt: **14828235.3**

(22) Date de dépôt: **17.12.2014**

(51) Int Cl.:
**B60L 1/00** *(2006.01)*    **G01R 31/36** *(2019.01)*

(86) Numéro de dépôt international:
**PCT/FR2014/053404**

(87) Numéro de publication internationale:
**WO 2015/101731 (09.07.2015 Gazette 2015/27)**

(54) **MÉTHODE POUR ESTIMER L'APTITUDE D'UNE BATTERIE À FOURNIR UN PROFIL DE PUISSANCE PRÉDÉTERMINÉ**

VERFAHREN ZUR SCHÄTZUNG DER EIGNUNG EINER BATTERIE ZUR SPEISUNG EINES VORBESTIMMTEN LEISTUNGSPROFILS

METHOD FOR ESTIMATING THE ABILITY OF A BATTERY TO SUPPLY A PREDETERMINED POWER PROFILE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **06.01.2014 FR 1450057**

(43) Date de publication de la demande:
**16.11.2016 Bulletin 2016/46**

(73) Titulaire: **Renault s.a.s**
**92100 Boulogne-Billancourt (FR)**

(72) Inventeurs:
• **SAINT MARCOUX, Antoine**
**F-91120 Palaiseau (FR)**
• **FONTAINE, Gauthier**
**F-62840 Neuve Chapelle (FR)**

• **DELOBEL, Bruno**
**F-75015 Paris (FR)**

(56) Documents cités:
**US-A- 6 118 252    US-A1- 2006 208 739**
**US-B2- 7 741 805**

• **SHEN ET AL: "Adaptive online state-of-charge determination based on neuro-controller and neural network", ENERGY CONVERSION AND MANAGEMENT, ELSEVIER SCIENCE PUBLISHERS, OXFORD, GB, vol. 51, no. 5, 1 mai 2010 (2010-05-01), pages 1093-1098, XP026894410, ISSN: 0196-8904, DOI: 10.1016/J.ENCONMAN.2009.12.015 [extrait le 2010-01-12]**

**Description**

La présente invention concerne une méthode pour estimer l'aptitude d'une batterie à fournir un profil de puissance prédéterminé. Elle s'applique notamment aux véhicules automobiles hybrides.

Dans le contexte actuel de consensus autour du réchauffement climatique, la diminution des émissions de dioxyde de carbone ($CO_2$) est un défi majeur auquel sont confrontés les constructeurs automobiles, les normes étant toujours plus exigeantes en la matière.

Outre l'amélioration constante des rendements des moteurs thermiques classiques, qui s'accompagne d'une baisse des émissions de $CO_2$, les véhicules électriques (« EV » d'après la terminologie anglo-saxonne « Electric Vehicle ») et les véhicules hybrides thermique-électrique (« HEV » d'après la terminologie anglo-saxonne « Hybrid Electric Vehicle ») sont aujourd'hui considérés comme la solution la plus prometteuse pour diminuer les émissions de $CO_2$. Différentes technologies de gestion de l'énergie électrique ont été testées dans les dernières années, afin de répondre aux besoins des EV et HEV.

Ainsi, il est connu de mettre en œuvre dans des HEV des architectures électriques de type « mild-hybrid » fonctionnant à tension sécuritaire inférieure à 60 volts (V). Une telle architecture électrique autorise l'utilisation d'un moteur électrique pour assister le moteur thermique, mais n'autorise pas ce moteur électrique à entraîner seul le HEV.

Par exemple, il est connu d'utiliser une batterie lithium-ion (Li-ion) dite « de traction » délivrant cette tension sécuritaire à un réseau de puissance sur lequel est branché une machine électrique, par exemple un alternodémarreur. Durant les phases de freinage ou de décélération, la machine électrique fonctionne comme une génératrice pour recharger la batterie : on parlera dans la suite de la présente demande de mode ou de phase de « freinage récupératif » pour désigner simplement ce mode de fonctionnement d'un HEV. Durant les phases de roulage, que ce soit à vitesse constante ou en accélération, il fonctionne principalement comme un moteur électrique en assistance du moteur thermique (même si des modes de fonctionnement intermédiaires peuvent exister), grâce à l'énergie préalablement stockée dans la batterie Li-ion durant des phases de freinage récupératif : on parlera dans la suite de la présente demande de mode ou de phase de « roulage » pour désigner simplement ce mode de fonctionnement d'un HEV.

La machine électrique peut également fournir une fonction d'arrêt et de redémarrage automatique du moteur thermique, de type « Stop & Start » selon la terminologie anglo-saxonne : dès que le véhicule s'immobilise au-delà d'un certain délai, par exemple devant un feu rouge à une intersection, le moteur thermique est automatiquement arrêté, puis automatiquement redémarré lorsque le conducteur appuie sur la pédale d'accélérateur quand le feu est passé au vert. L'intérêt de cette fonction « Stop & Start » est de diminuer encore la consommation de carburant et donc de diminuer encore les émissions de $CO_2$. Mais un inconvénient majeur de cette fonction est qu'elle est consommatrice de puissance électrique et qu'il est par conséquent nécessaire d'évaluer en permanence la capacité de la batterie à redémarrer le moteur thermique, de manière à ne pas l'arrêter si la batterie n'est plus capable de le redémarrer. Et faire cette évaluation n'est pas sans poser de nombreuses difficultés.

En effet, les performances de la batterie peuvent varier fortement en fonction de son état de charge, de sa température ou encore de son vieillissement. C'est une des raisons pour lesquelles, de manière classique, un calculateur dédié est intégré à cette batterie : c'est le « BMS » pour « Battery Management System » selon la terminologie anglo-saxonne. La principale fonction du BMS est de transmettre à d'autres calculateurs des informations sur l'état de la batterie, afin d'autoriser son utilisation au maximum de ses performances tout en restant dans sa plage d'utilisation nominale. Concrètement, le BMS mesure ou calcule, de manière embarquée et à chaque instant, plusieurs caractéristiques de la batterie, dont les principales sont le courant et la tension totale de la batterie, la tension de chaque cellule de la batterie, la température en différents points de la batterie, l'état de charge de la batterie (« SOC » pour « State Of Charge » selon la terminologie anglo-saxonne) qui est un pourcentage entre 0% et 100%, l'état de santé de la batterie (« SOHE » pour « State Of Health Energy » et « SOHP » pour « State Of Health Power » selon la terminologie anglo-saxonne) qui sont eux aussi des pourcentages entre 0% et 100%, l'énergie disponible restante en décharge ou encore la puissance disponible en décharge.

La puissance disponible en décharge est définie comme un niveau de puissance que la batterie pourrait transmettre pendant une durée minimale prédéterminée. D'habitude, son calcul se fait à chaque instant sans augurer du profil de roulage qui va être appliqué par la suite. En effet, par construction, le BMS ne peut connaître *a priori* quelle sera le besoin en puissance du conducteur pendant les 10 prochaines secondes. Cependant, dans certaines conditions spécifiques, notamment de « Stop & Start », le profil de puissance qui va être appliqué par la suite, est connu à l'avance. Et si le BMS indique que la batterie pourra fournir la puissance pour relancer le moteur thermique, alors le contrôleur du moteur thermique peut décider son arrêt, par exemple au moment d'une immobilisation du véhicule devant un feu rouge. Une autre situation dans laquelle le profil de puissance qui va être appliqué peut être connu à l'avance est lorsque la machine électrique doit assurer un transitoire de puissance prédéfini, par exemple lors d'un passage de vitesse pour atténuer la sensation de perte de couple du moteur thermique : la machine électrique peut avoir à fournir un surplus de puissance transitoire, qui est bien toujours le même. Dans la suite de la présente demande, ce profil de puissance connu à l'avance sera simplement désigné comme « le profil de puissance de référence » ou même comme « le profil de puissance ». Ainsi, pour assurer des fonctions comme le « Stop & Start » ou comme des transitoires de puissance aux changements de vitesse, la question n'est pas de déterminer quel est le niveau de puissance que la batterie pourrait maintenir pendant les 10 prochaines secondes, mais plutôt de déterminer si, oui ou non, la batterie est capable de fournir ce profil de puissance de référence sans se trouver en sous-tension.

Et il faut bien comprendre que cette question est cruciale. Dans le cas du « Stop & Start », si le BMS indique que la batterie ne peut pas fournir le profil de puissance de référence pour redémarrer le moteur thermique, alors qu'en réalité elle peut le faire, alors, même en phase d'immobilisation du véhicule, le moteur thermique va continuer à tourner et causer une surconsommation de carburant et des émissions de CO2 indues. Dans le cas des transitoires de puissance, si le BMS indique que la batterie peut fournir le profil de puissance de référence pour assurer un transitoire de puissance, alors qu'en réalité elle ne le peut pas, alors soit la batterie va entrer en sous-tension, ce qui peut avoir des effets secondaires sur le circuit haute-tension ou même sur le circuit basse tension, notamment un risque de « reset » de l'« Engine Control Unit » (ECU) selon la terminologie anglo-saxonne, ou encore un risque de dégradation accélérée des cellules de la batterie. Une autre possibilité est que la batterie ne fournisse vraiment pas le profil de puissance de référence, entraînant une dégradation de prestation perceptible par le conducteur. Dans le cas spécifique du « Stop & Start », si le BMS indique que la batterie peut fournir le profil de puissance de référence pour assurer un redémarrage, alors qu'en réalité elle ne le peut pas, alors le conducteur sera en panne immobilisante. !

Le brevet US 7,741,805 divulgue une méthode assez évoluée pour estimer de manière adaptative la puissance disponible dans une batterie, dans le but de démarrer un moteur thermique. Cette méthode utilise des estimations de la résistance interne de la batterie calculées sur un historique récent pour ré-estimer la puissance disponible en décharge à court terme. A court terme seulement, car cette méthode se fonde sur une relation empirique permettant de déduire « de proche en proche » la nouvelle valeur de la résistance interne, cette relation faisant implicitement l'hypothèse que les conditions générales de fonctionnement n'ont pas ou peu changé, notamment le SOC et la température. Un des principaux inconvénients de cette méthode est donc qu'elle est moins efficace dès lors que les conditions générales de fonctionnement ont beaucoup changé depuis le dernier démarrage, par exemple après une phase prolongée de roulage qui aura fait considérablement varier le SOC et la température. Il s'agit là d'un inconvénient que la présente invention se propose de résoudre.

Le document "Adaptive online state-of-charge détermination based on neuro-controller and neural network" (SHEN ET AL, ENERGY CONVERSION AND MANAGEMENT, ELSEVIER SCIENCE PUBLISHERS, OXFORD, GB, vol. 51, no. 5, 1 mai 2010, pages 1093-1098) divulgue un procédé d'estimation de SOC d'une batterie et présente des inconvénients similaires.

La présente invention a pour but de résoudre les inconvénients précités, notamment de rester fiable même s'il y a une grande variation de SOC et/ou de température entre deux redémarrages du moteur thermique. Pour cela, l'invention s'appuie notamment sur une loi de probabilité, qui est non seulement globale sur l'ensemble des plages d'utilisation en température et en SOC, mais qui est également basée sur un historique ancien d'utilisation. A cet effet, l'invention a pour objet un procédé pour déterminer l'aptitude ou l'inaptitude d'une batterie à fournir un niveau de puissance prédéterminé pendant une durée prédéterminée. Il comporte une étape d'estimation de l'état de charge SOC de la batterie, une étape de mesure de la température T de la batterie, ainsi qu'une étape de détermination, à partir de l'état SOC estimé et de la température T mesurée, de l'aptitude ou de l'inaptitude de la batterie par utilisation d'un modèle statistique adaptatif.

Dans un mode de réalisation préférentiel, l'étape de détermination peut avantageusement inclure une étape d'estimation, à partir de l'état SOC estimé et de la température T mesurée, d'une probabilité $P_\alpha(SOC,T)$ pour que la batterie soit apte, où $P_\alpha$ désigne une loi de probabilité à au moins un paramètre a valant a1 . Elle peut également inclure, si $P_{\alpha=\alpha1}(SOC,T) \geq P_{seuil}$ où $P_{seuil}$ désigne un seuil de probabilité entre 0 et 1, une étape de fourniture par la batterie de la puissance prédéterminée pendant la durée prédéterminée, cette étape de fourniture pouvant elle-même inclure une sous-étape de mesure d'une tension $V_{min}$ aux bornes de la batterie pendant la fourniture, une sous-étape de mesure d'un courant $I_{max}$ traversant la batterie pendant la fourniture, ainsi que, si $V_{min} \leq V_{seuil}$ ou si $I_{max} \geq I_{seuil}$, où $V_{seuil}$ désigne un seuil en tension et $I_{seuil}$ désigne un seuil en intensité, une sous-étape de modification de la valeur du paramètre $\alpha$ à une valeur $\alpha2$ de telle sorte que $P_{\alpha=\alpha2}(SOC,T) < P_{\alpha=\alpha1}(SOC,T)$.

Dans un mode de réalisation préférentiel, la loi de probabilité $P_\alpha$ peut avantageusement être une loi de régression à 3 paramètres $\alpha$, $\beta$ et $\gamma$ telle que $P_\alpha(SOC,T) = P_{\alpha,\beta,\gamma}(SOC,T) = \dfrac{1}{1+e^{-(\alpha \cdot SOC + \beta \cdot T_{bat} + \gamma)}}$ .

Dans un mode de réalisation préférentiel, la sous-étape de modification des valeurs des paramètres $\alpha$, $\beta$ et $\gamma$ peut avantageusement être réalisée itérativement à chaque fourniture par la batterie de la puissance prédéterminée pendant la durée prédéterminée, de telle sorte que la loi de probabilité $P_{\alpha,\beta,\gamma}$ tende vers une loi de probabilité idéale en fin de vie de la batterie.

Dans un mode de réalisation préférentiel, la loi $P_{\alpha,\beta,\gamma}$ peut avantageusement être la fonction d'activation d'un réseau de neurones ayant $\alpha$, $\beta$ et $\gamma$ comme coefficients de pondération, lesdits coefficients pouvant être mis à jour dans la sous-étape de modification par apprentissage dudit réseau de neurone.

L'invention a également pour objet un programme d'ordinateur comprenant des instructions de code de programme pour l'exécution des étapes d'un tel procédé, lorsque ledit programme est exécuté sur un ordinateur.

L'invention a également pour objet un véhicule électrique ou hybride comportant un calculateur exécutant un tel programme.

La présente invention a encore pour principal avantage que, si plusieurs jours auparavant le redémarrage du moteur thermique avait entraîné un passage en sous-tension, alors l'estimateur selon l'invention est capable d'en tenir compte via sa loi de probabilité.

D'autres caractéristiques et avantages de l'invention apparaîtront à l'aide de la description qui suit faite en regard de dessins annexés qui représentent :

- les figures 1, 2, 3 et 4, par des graphes, les principes importants de l'invention ;
- les figures 5, 6 et 7, par des graphes, un exemple de réalisation de l'invention.

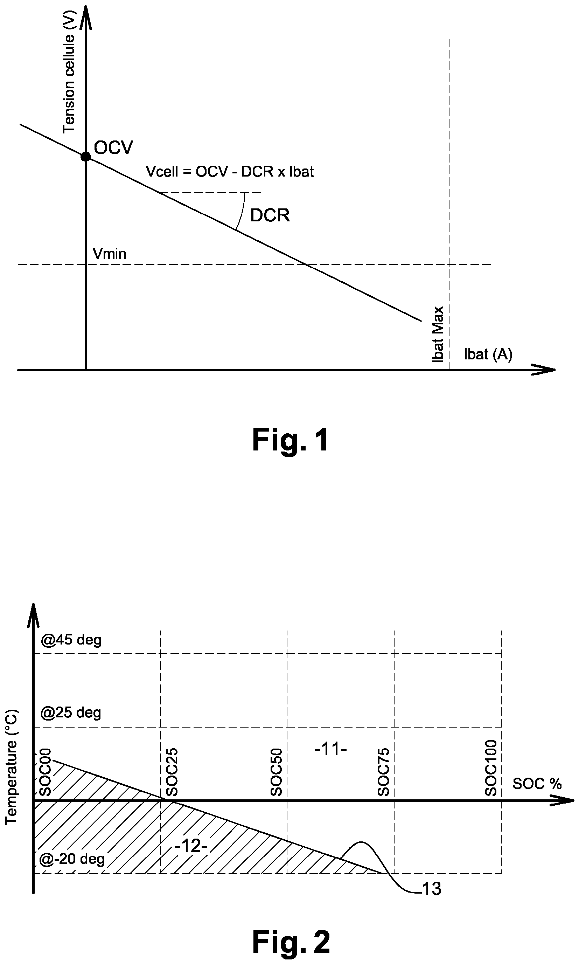

La puissance disponible en décharge *AvailablePower* selon la terminologie anglo-saxonne est définie comme la valeur maximale de puissance que peut fournir la batterie sans passer au-dessous d'un niveau de tension de coupure $V_{min}$ d'une part et sans dépasser un courant maximal de décharge $I_{bat\_MAX}$ d'autre part. Mathématiquement, comme illustré par le graphe de la figure 1 qui représente l'intensité $I_{bat\_MAX}$ en abscisse et la tension aux bornes d'une cellule en ordonnée, *AvailablePower* vaut :

$$AvailablePower = \min\left(V_{min} \cdot \frac{OCV - V_{min}}{DCR}, \left(OCV - DCR \cdot I_{bat\_MAX}\right) \cdot I_{bat\_MAX}\right)$$

Où :

- OCV désigne la tension à vide d'après la terminologie anglo-saxonne « Open Circuit Voltage » : à une valeur de SOC et une valeur de température données d'une cellule, correspond un niveau d'OCV de ladite cellule ;
- DCR désigne la résistance interne d'après la terminologie anglo-saxonne « Direct Current Résistance » : à une valeur de SOC et de température données d'une cellule, correspond un niveau de DCR de ladite cellule, celle-ci dépendant par ailleurs du vieillissement de la cellule.

Dans ces conditions :

- plus l'état de charge diminue, plus la puissance disponible en décharge diminue, car OCV est plus faible et DCR est plus élevée ;
- plus la température diminue, plus la puissance disponible en décharge diminue, car DCR est plus élevée.

La figure 2 illustre deux zones 11 et 12 à deux dimensions dans le plan de ladite figure, définies chacune par une plage de valeurs de SOC en abscisse et une plage de valeurs de température en ordonnée. Ainsi, pour un profil de décharge connu *a priori,* par exemple un pic de décharge de 40 kilowatts pendant 500 millisecondes :

- si la batterie est à SOC=100% et 45 degrés, c'est-à-dire dans la zone 11 de la figure 2, alors elle pourra fournir la puissance correspondant à ce profil sans tomber en sous-tension ;
- alors qu'à SOC=10% et -20°C, c'est-à-dire dans la zone 12 de la figure 2, alors elle ne pourra pas fournir la puissance correspondant à ce profil sans passer en sous-tension.

Comme illustré par la figure 2, il existe entre ces deux zones 11 et 12 une frontière illustrée par une droite 13 en pointillés, qui permet de discriminer si la batterie peut fournir ou pas le profil de puissance demandé.

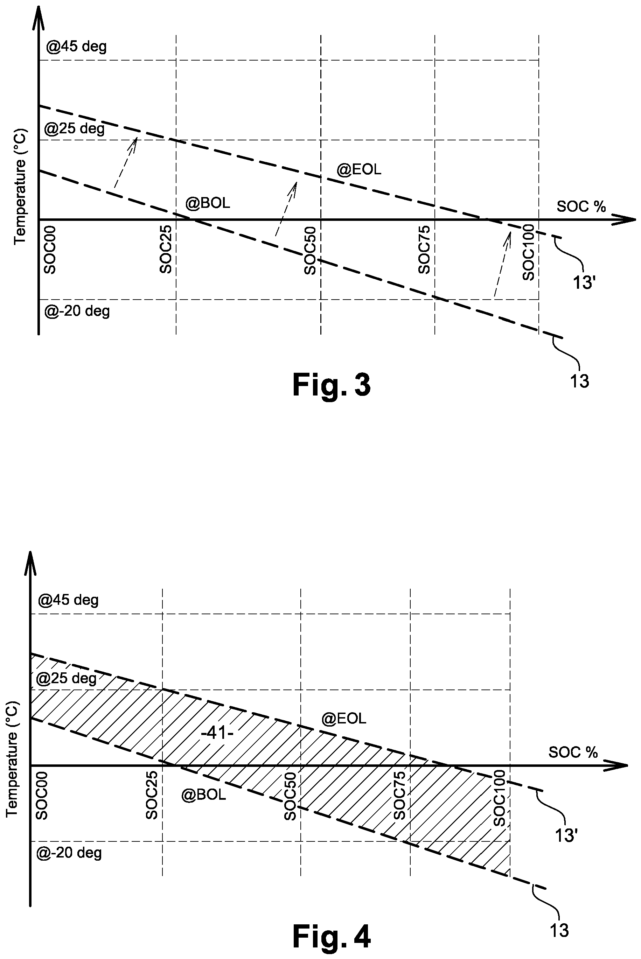

Or, toute batterie se dégrade au cours du temps. Cela se traduit par une diminution de sa capacité disponible et une augmentation de sa résistance interne. Dans ces conditions, la zone de (SOC, Température) où la batterie peut fournir le profil de puissance demandé diminue au cours du temps à cause du vieillissement. La figure 3 illustre, dans le même système d'axes que celui de la figure 2, le fait que la frontière 13, toujours illustrée par une droite en pointillés correspondant au début de la vie de la batterie (BOL signifiant « Beginning Of Life » selon la terminologie anglo-saxonne), permettant de discriminer entre la zone où la batterie peut fournir le profil de puissance demandé et la zone où la batterie ne peut pas fournir le profil de puissance demandé sans passer en sous-tension ou en surintensité, va se déplacer au cours du temps à cause du vieillissement, pour finalement correspondre à une autre droite 13' en pointillés (EOL signifiant « End Of Life » selon la terminologie anglo-saxonne). Un principe de l'invention est non pas de calculer quel est le niveau de puissance disponible, mais plutôt de suivre l'évolution de la frontière entre la droite 13 et la droite 13', afin de déterminer de manière adaptative la zone 11 où la batterie peut fournir le profil de puissance de référence.

En effet, si le BMS ne détermine pas de manière adaptative, conformément à l'invention, la zone 11 où la batterie peut fournir le profil de puissance de référence, alors on est obligé de considérer par défaut qu'on est dans le pire cas, c'est-à-dire de faire l'hypothèse que c'est la droite 13' qui, dès le début de la vie de la batterie, délimite la zone 11 de la zone 12. Cela revient donc à réduire arbitrairement la plage où la batterie est sollicitée pour fournir le profil de puissance de référence. Sur la figure 4, cela est illustré par une zone 41 dans laquelle, en début de vie de la batterie, il ne lui est pas demandé de fournir le profil de puissance de référence alors qu'elle le pourrait.

Pour éviter l'apparition de cette zone 41, un principe de l'invention est d'utiliser un modèle probabiliste de caractérisation de la capacité de la batterie à fournir le profil de puissance de référence, modèle qui soit mis à jour sur la base d'un retour d'expérience, plus exactement sur la base de la réaction en tension et en courant de la batterie lors des dernières fois où elle a dû fournir ce profil de puissance. En effet, une telle méthode adaptative permet d'utiliser ces informations de tension et de courant pour mettre à jour la probabilité pour que la batterie puisse fournir ce profil de puissance de référence. Un exemple de mise en œuvre est décrit dans la suite de la présente demande.

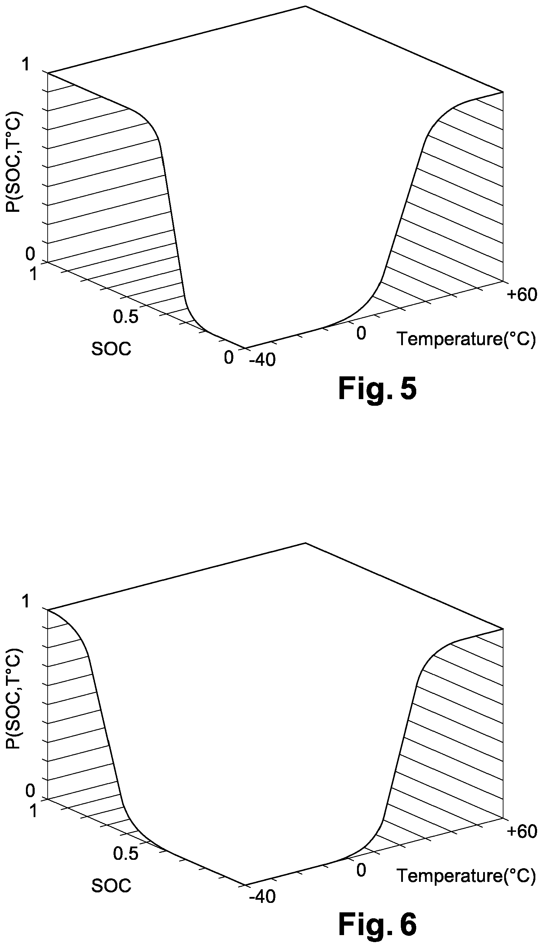

La suite de la présente de demande décrit, en regard des figures 5, 6 et 7, un exemple de réalisation de l'invention comportant plusieurs étapes.

Une première étape inclut de construire une probabilité de faire un décollage en fonction du SOC et de la température de la batterie. En effet, puisqu'il s'agit de prédire si la batterie sera capable ou non de fournir un profil de puissance connu, répété et demandé fréquemment, comme par exemple un pic de puissance pour assurer le redémarrage du moteur thermique, il est possible de suivre dans le temps le comportement et la réaction de la batterie à chaque fois qu'elle fournit ce profil de puissance, ceci par le biais de la vérification des exigences en termes de tension de coupure et de courant maximal au cours d'un pic de puissance. Un principe de la présente invention est de tirer profit de l'information donnée par chaque occurrence du profil de référence de courte durée, pour prendre en compte l'évolution des caractéristiques de la batterie au cours de son vieillissement. C'est pourquoi on peut dire que la méthode selon l'invention est une méthode adaptative.

Pour déterminer la capacité de la batterie à fournir le profil de puissance de référence quand la demande en est faite, il faut tout d'abord connaître l'état dans lequel se trouve la batterie. Dans le cas du « stop & start », cet état peut être défini comme un état ($SOC, T_{bat}$) de taille 2 où SOC désigne l'état de charge de la batterie entre 0% et 100% et $T_{bat}$ désigne sa température en degrés Celsius (°C).

On peut déterminer ensuite une loi de probabilité *p* qui donne la probabilité pour que la batterie fournisse le profil de puissance lorsqu'elle est dans l'état ($SOC, T_{bat}$), par :

$$p(SOC, T_{bat}) = \frac{1}{1 + e^{-(\alpha \cdot SOC + \beta \cdot T_{bat} + \gamma)}}$$

où $\alpha$, $\beta$, $\gamma$ sont des coefficients réels.

La forme de la loi de probabilité, en régression logistique dans le présent exemple de réalisation, est fixée pour toute la vie de la batterie. Par contre, les valeurs des coefficients $\alpha$, $\beta$, $\gamma$, dits « coefficients de régression », vont varier au cours de l'utilisation de cette dernière, sachant que l'on a N+1 coefficients de régression si N désigne la taille de l'état caractérisant la batterie. C'est l'évolution de ces coefficients qui assure avantageusement le caractère adaptatif de la méthode selon l'invention. Ainsi, lorsqu'une demande du profil de puissance de référence est faite, la probabilité précédente est calculée en fonction de l'état courant de la batterie.

Une deuxième étape inclut de comparer cette probabilité a un seuil afin de déterminer si, dans son état actuel, la batterie peut fournir ou pas le profil de puissance de référence. Cette probabilité est ensuite comparée à un seuil $p_{décision}$ de décision (par exemple, $p_{décision}$ = 0.5) :

- si $p(SOC, T_{bat}) < p_{décision}$, alors on considère que la batterie ne peut pas fournir le profil de puissance demandé, qui ne sera pas fourni : on ne pourra donc pas vérifier si la décision était bonne ou non ;
- sinon, on considère que la batterie peut fournir le profil de puissance demandé, qui sera fourni au moment voulu : on pourra confirmer si la décision prise était la bonne en constatant si les exigences en termes de tension de coupure et de courant maximal sont vérifiées ou pas pendant la fourniture du profil de référence ; avantageusement, ces dernières informations récoltées vont permettre de faire évoluer les N+1 coefficients de régression.

En combinaison avec l'utilisation d'un seuil de décision, la forme simple de la loi de probabilité donnée précédemment permet de diviser l'espace des états de la batterie en deux zones, l'une de rejet et l'autre d'acceptation, ces deux zones étant séparées par un hyperplan. L'évolution des coefficients de régression $\alpha$, $\beta$, $\gamma$ au cours de la vie de la batterie permet de faire évoluer cet hyperplan séparateur.

Une troisième étape inclut de mettre à jour la loi probabilité sur la base de la réaction de la batterie suite à l'application de ce profil de puissance. L'évolution des coefficients $\alpha$, $\beta$, $\gamma$ à chaque occurrence du profil de puissance de référence peut être simple en faisant une analogie avec les réseaux de neurones artificiels. En fait, l'expression de notre probabilité correspond à un réseau de neurones à 2 couches dont les poids sont les coefficients de la régression et dont la fonction d'activation est une sigmoïde. L'utilisation de méthodes standards dans le domaine des réseaux de neurones artificiels pour faire évoluer les poids du réseau au cours d'un apprentissage supervisé, c'est-à-dire les coefficients de la régression, peut être faite. Ainsi, une rétro-propagation du gradient peut être par exemple utilisée pour faire évoluer les coefficients $\alpha$, $\beta$, $\gamma$ au cours de la vie de la batterie.

On a un exemple d'apprentissage à chaque fois que le profil de référence est appliqué. Donc, au moment où le profil de puissance a été demandé, le calcul de $p(SOC, T_{bat})$ a été réalisé et on avait $p(SOC, T_{bat}) > p_{décision}$. Au cours de la fourniture du profil de référence, l'exactitude de la décision est vérifiée par rapport à la tension de coupure et au courant maximal. Ainsi, si la tension minimale cellule devient inférieur à une tension seuil $V_{seuil}$ (elle-même supérieure ou égale à une tension $V_{min}$) pendant le pic de puissance, ou si le courant batterie dépasse un courant maximal de décharge autorisé $I_{bat\_MAX}$, alors on effectue un apprentissage et on fait évoluer les coefficients $\alpha$, $\beta$, et $\gamma$.

Par exemple, en utilisant une rétro-propagation du gradient, avec l'exemple constitué de l'état courant, de $p(SOC, T_{bat})$ précédemment calculé et d'une probabilité idéale $p_{idéal}(SOC, T_{bat})$ que l'on aurait souhaité en sortie du réseau de neurones et que l'on calcule en fonction de la distance entre la réaction réelle de la batterie et les exigences.

Dans l'exemple décrit précédemment, la méthode d'apprentissage ne correspond pas à une méthode de classification, c'est-à-dire de séparation entre une classe positive et une classe négative, mais à une méthode de régression où on cherche à faire évoluer la probabilité $p$. Dans le cas présent, puisqu'on empêche la fourniture du profil de puissance lorsque la décision est négative, on a en effet très peu d'exemples négatifs par rapport au nombre d'exemples positifs : uniquement en cas d'erreur, c'est-à-dire lorsqu'on avait décidé que l'on pouvait fournir le profil de puissance, mais que finalement on n'y parvient pas. Dans l'idéal, le nombre d'exemples négatifs doit même être rendu nul. Mais ceci pose problème pour certaines méthodes d'apprentissage de classifieurs binaires. L'utilisation de l'expression de $p$ et de la régression permet d'apprendre en fonction de la valeur de $p$, ce qui permet une adaptation différente au sein même de l'ensemble des exemples positifs. L'apprentissage se fait aussi dans un voisinage de la frontière de décision et non pas dans tout l'espace des états, ce qui est important, car c'est l'évolution de la frontière de décision qui est le critère primordial.

Enfin, l'initialisation des coefficients $\alpha$, $\beta$ et $\gamma$ en début de vie de la batterie peut se faire par un pré-calcul, de manière à avoir ainsi directement des coefficients qui correspondent à une batterie neuve. Elle peut se faire par apprentissage par rétro-propagation du gradient de manière adaptative, ou en faisant la régression linéaire de l'hyperplan séparateur sur des exemples puis en laissant une marge suffisante pour la décision par rapport à cet hyperplan.

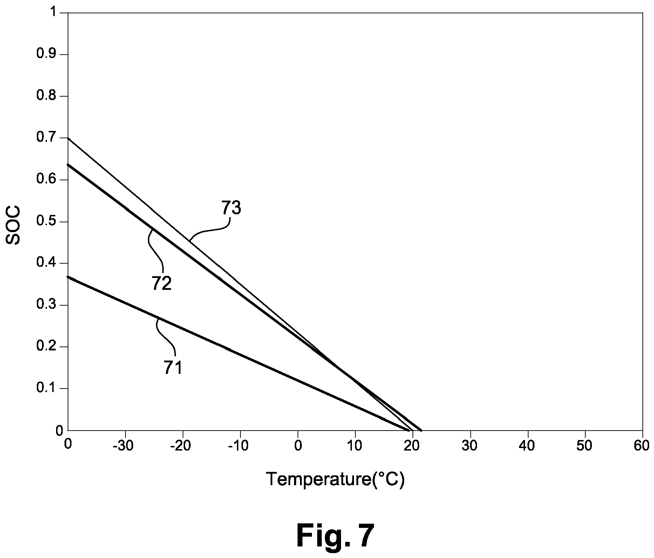

Un exemple de loi de probabilité $p(SOC, T_{bat})$ en début de vie est illustrée à la figure 5 et peut par exemple évoluer en fin de vie vers la loi de probabilité illustré à la figure 6 : en comparaison, ces deux figures illustrent bien le fait qu'une baisse du SOC fait baisser la probabilité de pouvoir fournir le profil de référence beaucoup plus vite en fin de vie qu'en début de vie. L'évolution des frontières de décision par la méthode décrite est illustrée à la figure 7 : une droite 71 illustre la frontière de décision en début de vie, une droite 72 illustre la frontière de décision en fin de vie par adaptation et apprentissage, une droite 73 illustre la frontière idéale de décision en fin de vie, particulièrement pessimiste.

Il faut bien comprendre que d'autres approches de modélisation de la zone où la batterie peut fournir le profil de puissance sont possibles, qu'elles soient ou non paramétriques. On peut ainsi citer les méthodes CART (« Classification & Régression Tree » selon l'expression anglo-saxonne], SVM (« Support Vector Machine » selon l'expression anglo-saxone »), les méthodes à noyau ou encore des méthodes incluant la construction d'une base de données avec des points dans différentes zones de SOC et de température. Il faut en tout cas que la méthode soit adaptative : il faut être capable de créer une configuration en début de vie, puis pouvoir la faire évoluer algorithmiquement au fur et à mesure que des exemples arrivent à chaque demande de fourniture du profil de référence, sans toutefois devoir refaire tout l'apprentissage depuis l'origine, ceci pour pouvoir oublier les exemples au fur et à mesure qu'ils ont été utilisés dans l'apprentissage. De plus, l'ensemble d'apprentissage ne contenant qu'un élément, l'influence des exemples connus en début de vie ne se fait pas sentir à chaque itération d'apprentissage par cette méthode, ce qui permet de mieux s'adapter à l'évolution des caractéristiques de la batterie au cours de son utilisation.

Il faut toutefois noter que l'emploi de méthodes de classification pure risque de poser problème, à cause notamment du très faible nombre d'exemples négatifs. Alors qu'une méthode de régression avec décision par seuil, comme dans l'exemple de réalisation qui précède, permet d'apprendre en fonction d'un critère mesurable par rapport aux exigences et permet d'éviter la distinction entre exemples positifs et exemples négatifs. L'apprentissage se fait dans les basses températures uniquement car, dans cette zone, la frontière séparatrice est quasiment linéaire. Pour les plus hautes températures, le problème n'a lieu que pour les très bas niveaux de SOC. On ne peut pas avoir de bonnes performances par une séparation linéaire sur l'ensemble des températures. Il faut donc traiter différemment basses et hautes températures.

Il faut noter également que, même si l'hyperplan demeure simple, permet de faire évoluer un nombre très limité de coefficients, d'éviter le sur-apprentissage et offre de bonnes performances car la surface de séparation effective est quasi-linéaire, l'utilisation d'une surface de séparation plus complexe est possible mais demande l'évaluation de plus de paramètres de régression et nécessite plus d'exemples d'apprentissage.

L'invention décrite précédemment a donc pour principal avantage que, en se concentrant sur un seul profil de puissance de référence, elle permet de prédire de manière plus précise la capacité de la batterie à fournir ce profil de puissance de référence que si la batterie devait uniquement indiquer quelle serait sa puissance disponible pendant quelques secondes.

Outre les HEV, cette invention peut également être appliquée sur les EV, ainsi qu'à n'importe quel chimie utilisée pour les batteries, qu'il s'agisse de Lithium-ion, Nickel-Métal-Hydrure, de Nickel-Cadmium ou de Plomb.

## Revendications

1. Procédé pour déterminer l'aptitude ou l'inaptitude d'une batterie à fournir un niveau de puissance prédéterminé pendant une durée prédéterminée, comportant :

   • une étape d'estimation de l'état de charge SOC de la batterie ;
   • une étape de mesure de la température T de la batterie ;
   • une étape de détermination, à partir de l'état SOC estimé et de la température T mesurée, de l'aptitude ou de l'inaptitude de la batterie par utilisation d'un modèle statistique adaptatif, le procédé étant **caractérisé en ce que** ladite étape de détermination inclut :

     ◦ une étape d'estimation, à partir de l'état SOC estimé et de la température T mesurée, d'une probabilité $P_\alpha$(SOC,T) pour que la batterie soit apte, où $P_\alpha$ désigne une loi de probabilité à au moins un paramètre a valant a1 ;
     ◦ si $P_{\alpha=\alpha1}$(SOC,T)$\geq$P$_{seuil}$ où P$_{seuil}$ désigne un seuil de probabilité entre 0 et 1, une étape de fourniture par la batterie de la puissance prédéterminée pendant la durée prédéterminée, incluant :

       une sous-étape de mesure d'une tension V$_{min}$ aux bornes de la batterie pendant la fourniture ;
       une sous-étape de mesure d'un courant I$_{max}$ traversant la batterie pendant la fourniture ;

     ◦ si V$_{min}\leq$V$_{seuil}$ ou si I$_{max}\geq$I$_{seuil}$, où V$_{seuil}$ désigne un seuil en tension et I$_{seuil}$ désigne un seuil en intensité, une sous-étape de modification de la valeur du paramètre $\alpha$ à une valeur $\alpha2$ de telle sorte que $P_{\alpha=\alpha2}$(SOC,T)<$P_{\alpha=\alpha1}$(SOC,T).

2. Procédé selon la revendication 1, **caractérisé en ce que** la loi de probabilité $P_\alpha$ est une loi de régression à 3 paramètres $\alpha$, $\beta$ et $\gamma$ telle que $P_\alpha(SOC,T)=P_{\alpha,\beta,\gamma}(SOC,T)= \dfrac{1}{1+e^{-(\alpha \cdot SOC + \beta \cdot T_{bat} + \gamma)}}$ .

3. Procédé selon la revendication 2, **caractérisé en ce que** la sous-étape de modification des valeurs des paramètres $\alpha$, $\beta$ et $\gamma$ est réalisée itérativement à chaque fourniture par la batterie de la puissance prédéterminée pendant la durée prédéterminée, de telle sorte que la loi de probabilité $P_{\alpha,\beta,\gamma}$ tende vers une loi de probabilité idéale en fin de vie de la batterie.

4. Procédé selon la revendication 3, **caractérisé en ce que** la loi $P_{\alpha,\beta,\gamma}$ est la fonction d'activation d'un réseau de neurones ayant $\alpha$, $\beta$ et $\gamma$ comme coefficients de pondération, lesdits coefficients étant mis à jour dans la sous-étape de modification par apprentissage dudit réseau de neurone.

5. Programme d'ordinateur, comprenant des instructions de code de programme pour l'exécution des étapes du procédé selon l'une quelconque des revendications précédentes, lorsque ledit programme est exécuté sur un ordinateur.

6. Véhicule électrique ou hybride comportant un calculateur, **caractérisé en ce que** ledit calculateur est configuré pour exécuter le programme selon la revendication précédente.

**Patentansprüche**

1. Verfahren zum Bestimmen der Eignung einer Batterie, ein vorbestimmtes Leistungsniveau während einer vorbestimmten Dauer abzugeben, umfassend:

   • einen Schritt des Schätzens des Ladezustands SOC der Batterie;
   • einen Schritt des Messens der Temperatur T der Batterie;
   • einen Schritt des Bestimmens, anhand des geschätzten Zustands SOC und der gemessenen Temperatur T, der Eignung oder Nichteignung der Batterie durch Verwenden eines adaptiven statistischen Modells, wobei das Verfahren **dadurch gekennzeichnet ist, dass** der Schritt des Bestimmens beinhaltet:

      ◦ einen Schritt des Schätzens, anhand des geschätzten Zustands SOC und der gemessenen Temperatur T, einer Wahrscheinlichkeit $P_\alpha(SOC,T)$, dass die Batterie geeignet ist, wobei $P_\alpha$ ein Wahrscheinlichkeitsgesetz mit mindestens einem Parameter $\alpha$ gleich $\alpha1$ ist;
      ◦ wenn $P_{\alpha=\alpha1}(SOC, T) \geq P_{seuil}$, worin $P_{seuil}$ einen Wahrscheinlichkeitsschwellenwert zwischen 0 und 1 bezeichnet, einen Schritt des Abgebens der vorbestimmten Leistung während der vorbestimmten Dauer durch die Batterie, beinhaltend:

         einen Teilschritt des Messens einer Spannung $V_{min}$ an den Klemmen der Batterie während der Abgabe;
         einen Teilschritt des Messens eines Stroms $I_{max}$, der während der Abgabe durch die Batterie fließt;

      ◦ wenn $V_{min} \leq V_{seuil}$ oder wenn $I_{max} \geq I_{seuil}$, worin $V_{seuil}$ einen Spannungsschwellenwert bezeichnet und $I_{seuil}$ einen Stromschwellenwert bezeichnet, einen Teilschritt des Änderns des Werts des Parameters $\alpha$ in einen Wert $\alpha2$, so dass $P_{\alpha=\alpha2}(SOC, T) < P_{\alpha=\alpha1}(SOC, T)$.

2. Verfahren nach Anspruch 1, **dadurch gekennzeichnet, dass** das Wahrscheinlichkeitsgesetz $P_\alpha$ ein Regressionsgesetz mit 3 Parametern $\alpha$, $\beta$ und $\gamma$ ist, so dass $P_\alpha(SOC, T) = P_{\alpha,\beta,\gamma}(SOC, T) = \dfrac{1}{1 + e^{-(\alpha \cdot SOC + \beta \cdot T_{bat} + \gamma)}}$.

3. Verfahren nach Anspruch 2, **dadurch gekennzeichnet, dass** der Teilschritt des Änderns der Werte der Parameter $\alpha$, $\beta$ und $\gamma$ bei jeder Abgabe der vorbestimmten Leistung während der vorbestimmten Dauer durch die Batterie iterativ ausgeführt wird, so dass das Wahrscheinlichkeitsgesetz $P_{\alpha,\beta,\gamma}$ am Ende der Lebensdauer der Batterie zu einem idealen Wahrscheinlichkeitsgesetz tendiert.

4. Verfahren nach Anspruch 3, **dadurch gekennzeichnet, dass** das Gesetz $P_{\alpha,\beta,\gamma}$ die Aktivierungsfunktion eines neuronalen Netzes mit $\alpha$, $\beta$ und $\gamma$ als Gewichtungskoeffizienten ist, wobei die Koeffizienten im Teilschritt des Änderns durch Lernen des neuronalen Netzes aktualisiert werden.

5. Computerprogramm, das Programmcodeanweisungen umfasst, die bei der Ausführung des Programms auf einem Computer die Schritte des Verfahrens nach einem der vorhergehenden Ansprüche ausführen.

6. Elektro- oder Hybridfahrzeug mit einem Rechner, **dadurch gekennzeichnet, dass** der Rechner dazu konfiguriert ist, das Programm nach dem vorhergehenden Anspruch auszuführen.

**Claims**

1. Method for determining the ability or inability of a battery to supply a predetermined power level for a predetermined time, comprising:

   • a step of estimation of the state of charge SOC of the battery;
   • a step of measurement of the temperature T of the battery;
   • a step of determination, from the estimated state SOC and from the measured temperature T, of the ability or of the inability of the battery through the use of an adaptive statistical model, the method being **characterized in that** said determination step includes:

∘ a step of estimation, from the estimated state SOC and from the measured temperature T, of a probability $P_\alpha(SOC,T)$ of the battery being capable, in which $P_\alpha$ denotes a probability law with at least one parameter $\alpha$ with the value $\alpha 1$;

∘ if $P_{\alpha=\alpha 1} (SOC, T) \geq P_{threshold}$, in which $P_{threshold}$ denotes a probability threshold between 0 and 1, a step of supply, by the battery, of the predetermined power for the predetermined time, including:

a substep of measurement of a voltage $V_{min}$ at the terminals of the battery during the supply;
a substep of measurement of a current $I_{max}$ passing through the battery during the supply;

∘ if $V_{min} \leq V_{threshold}$ or if $I_{max} \geq I_{threshold}$, in which $V_{threshold}$ denotes a voltage threshold and $I_{threshold}$ denotes a current threshold, a substep of modification of the value of the parameter $\alpha$ to a value $\alpha 2$ such that $P_{\alpha=\alpha 2}(SOC, T) < P_{\alpha=\alpha 1} (SOC, T)$ .

2. Method according to Claim 1, **characterized in that** the probability law $P_\alpha$ is a regression law with 3 parameters $\alpha$, $\beta$ and $\gamma$ such that $P_\alpha(SOC,T)=P_{\alpha,\beta,\gamma}(SOC,T)= \dfrac{1}{1+e^{-(\alpha \cdot SOC + \beta \cdot T_{bat} + \gamma)}}$ .

3. Method according to Claim 2, **characterized in that** the substep of modifying the values of parameters $\alpha$, $\beta$ and $\gamma$ is performed iteratively each time the predetermined power is supplied by the battery for the predetermined time, such that the probability law $P_{\alpha,\beta,\gamma}$ tends toward an ideal probability law at the end of life of the battery.

4. Method according to Claim 3, **characterized in that** the law $P_{\alpha,\beta,\gamma}$ is the function of activation of a neural network having $\alpha$, $\beta$ and $\gamma$ as weighting coefficients, said coefficients being updated during the substep of modification through learning of said neural network.

5. Computer program, comprising program code instructions for the execution of the steps of the method according to any one of the preceding claims, when said program is run on a computer.

6. Electric or hybrid vehicle comprising a computer, **characterized in that** said computer is configured to run the program according to the preceding claim.

Fig. 1

Fig. 2

Fig. 3

Fig. 4

Fig. 5

Fig. 6

**Fig. 7**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

• US 7741805 B

**Littérature non-brevet citée dans la description**

• Adaptive online state-of-charge détermination based on neuro-controller and neural network. **SHEN et al.** ENERGY CONVERSION AND MANAGEMENT. EL-SEVIER SCIENCE PUBLISHERS, 01 Mai 2010, vol. 51, 1093-1098